# EUROPEAN PATENT SPECIFICATION

(11) **EP 1 628 243 B1**
(45) Date of publication and mention of the grant of the patent: **23.07.2008**
(21) Application number: 04733146.7
(22) Date of filing: 14.05.2004
(51) Int. Cl.: G06K 19/077, H01L 23/498

(54) **IC CARD AND IC CARD MAKING METHOD**
CHIPKARTE UND CHIPKARTENHERSTELLUNGSVERFAHREN
CARTE A CIRCUIT INTEGRE ET PROCEDE DE FABRICATION D'UNE CARTE A CIRCUIT INTEGRE

(30) Priority: 23.05.2003 JP 2003146759
(43) Date of publication of application: 22.02.2006
(73) Proprietor: Konica Minolta Photo Imaging, Inc., Shinjuku-ku, Tokyo 163-0512 (JP)
(72) Inventor: TAKAHASHI, Hideki Konica Minolta Photo Imaging Inc, Hino-shi, Tokyo 191-8511 (JP); KITAMURA, Shigehiro, Hino-shi, Tokyo 191-8511 (JP)
(74) Representative: Gover, Richard Paul
(86) International application number: PCT/JP2004/006898
(87) International publication number: WO 2004/104911

(56) References cited:
- EP-A- 1 243 442
- JP-A- 1 244 625
- JP-A- 10 058 873
- JP-A- 11 204 566

## Description

### TECHNICAL FIELD

The present invention relates to a non-contact-type electronic card which records personal information requiring security with respect to prevention of such as forgery or alternation, or an IC card incorporated with an IC module comprising an IC chip that is suitably applied to a sheet and an antenna and an IC card producing method.

### TECHNICAL BACKGROUND

As an identification card (ID card) or a credit card, a magnetic card which records data by means of a conventional magnetic recording method has been commonly utilized. However, a magnetic card had problems of insufficient anti-tampering with data due to the ease of rewriting of the data, of insufficient protection of data due to environmental susceptibility of magnetic record and of insufficient memory capacity. Therefore, an IC card including an IC-chip has become popular in recent years.

An IC card exchanges data with external equipment by reading and writing, through an electric connection provided on the surface or a loop antenna in the card. An IC card is provided with larger memory capacity compared to a magnetic card and has been significantly improved also in security. Particularly, a noncontact-type IC card, which is provided with an antenna inside the card and without having an electric connection outside the card, is superior in security compared to a contact-type IC card which has an electric connection on the card surface, and has become to be utilized in such application as an IC card which highly requires secrecy and prevention of forgery or alternation.

As such an IC card, for example, there is known a card in which the first sheet material and the second sheet material are laminated sandwiching an adhesive and an IC module including an IC-chip and an antenna are sealed in the adhesive layer.

Since an IC card requires high security, durability of an IC card has become important in respect to prevention of forgery or alternation. Particularly, since an electric part such as an antenna for information exchange between an IC-chip and the outside are included inside the card, various attempts to assure durability thereof has been performed. However, in accordance with becoming popular in various applications, further high durability has been required.

Commonly used IC chips are made of the single crystals of silicon sliced into disks as silicon substrates. Subsequent to formation and diffusion of various types of semiconducting layers, wiring is performed through a circuit contact hole using an aluminum thin film. According to a widely known method, after aluminum film have been coated on all the surfaces, partial etching is provided so as to leave a wired portion (circuit formation layer). The circuit surface in the sense in which it is used in the present invention refers to the surface wired by an aluminum thin film and others.

Further, a resin-made protective layer having a thickness of about several µm is generally provided in order to protect the electrical circuit formed in the aforementioned manner against external contamination and unauthorized access, and to maintain the mechanical strength.

If required, the surface of the silicon substrate opposite to the circuit surface is provided with a thin film to a predetermined thickness. This is cut into chips, whereby IC chips are produced.

The aforementioned IC chip in the present invention includes the structure wherein a semiconducting layer, circuit formation layer and protective layer are formed on one side of the thickest silicon substrate.

In recent years, there is an active demand for a thin-film IC card and IC tag, and this has led to a demand for a thin-film silicon substrate. Many production methods for thin-film silicon substrate have been developed.

However, formation of a thin film involves the problem of reducing the strength due to external mechanical stress. Internal stress tends to be accumulated in the electrical circuit due to the difference in shrinkage rate of various materials used in composite layers.

Especially, the resins used in the protective layer have different shrinkage rates in most cases. Warpage may occur on the side of the chip protective layer (circuit side) by producing a thin-film chip, because of the difference in the thickness ratio of resins between the silicon layer and protective layer, and the shrinkage rate.

However, if this layer is corrected to a flat form and a reinforcement plate is provided, internal stress will accumulate in the electrical circuit, with the result that the strength deteriorates. Such disadvantages will occur. Further, an electrical circuit is present on one side with respect to the silicon substrate. Accordingly, when the electrical circuit becomes concave due to bending stress, the curvature radius is greater than that on the surface opposite to the circuit surface, and this increases the amount of elongation when pulled toward the circuit surface. This tends to cause circuit damage.

Thus, because of the very nature of the structure, the aforementioned chip involves the problem of the stress on the circuit provided on the surface of the IC chip that must be studied and solved, from the viewpoint of durability.

By the very nature of the card, the card is always carried in the pocket of the trousers. The stress on this circuit is caused when it is repeatedly bent in the pocket, is dropped on the ground, or is pressed against the coin and others. To overcome such difficulties, the chip is required to have a high degree of durability through such improvements as installation of rigid reinforcements.

The durability problem caused by the breakdown of the IC chip due to pressure and bending, or the disconnection of the antenna, is discussed, for example, in Patent Documents 1 and 2. The curvature of the chip is disclosed in the Patent Documents 3 and 4.
[Patent Document 1] Official Gazette of Japanese Patent Tokkaihei 6-199083
[Patent Document 2] Official Gazette of Japanese Patent Tokkaihei 8-324166
[Patent Document 3] Official Gazette of Japanese Patent Tokkaihei 10-58873
[Patent Document 4] Official Gazette of Japanese Patent Tokkaihei 11-204566

However, some improvements in durability can be observed in the conventional card, but a sufficient durability for varied circumstances is not ensured. For example, when the IC chip is exposed to impact causing abrupt stress, repeated bending and repeated local loads, for example, the IC chip is subjected to cracking and the card is damaged. This has led to the problem of causing an electrical operation failure. Mere improvement of the durability is not sufficient. To allow the personal information to be described on the card, it is necessary to produce a smooth card surface free of variation in density, scratch or blur, using the sublimation printing and heat-fusion printing method.

One known IC card is disclosed in EP1243442A. This discloses an IC card including an IC module including an IC chip having a circuit surface, a reinforcement structural member adjacent to the non-circuit surface of the IC chip opposite to the circuit surface and an antenna, wherein the IC module is incorporated within the IC card by filling it with an adhesive.

Another known IC card is disclosed in JP11204566A. This discloses an IC card including an IC chip having a circuit surface and a reinforcement structural member adjacent to a non-circuit side of the IC chip opposite to the circuit surface side, in which the IC chip is incorporated in the IC card by a settable material.

### DISCLOSURE OF INVENTION

The object of the present invention is to provide an IC card and IC card manufacturing method wherein the IC chip, especially the IC chip containing a plurality of layers with different physical properties can be prevented from being damaged by the stress occurring on the circuit side, whereby the durability and surface properties are improved on higher levels.

To solve the aforementioned problems and to achieve the aforementioned object, the present invention provides the following structure:
An embodiment of the present invention for achieving the aforementioned object is an IC card, comprising: an IC module including
   an IC chip having a circuit surface side and an opposite side opposite to the circuit surface side;
   a reinforcement structural member arranged adjacent to the opposite side of the IC chip; and
   an antenna;
where the IC module is incorporated in the IC card by filling with an adhesive;
characterised in that the IC chip is fixed to the reinforcement structural member through a resin layer on a condition that the circuit surface side of the IC chip is curved in a concave shape.

A further embodiment of the present invention is an IC card producing method of producing an IC card in which an IC module having an IC chip having a circuit surface side and a opposite side opposite to the circuit surface side, a reinforcement structural member arranged adjacent to the opposite side of the IC chip, an antenna and an adhesive layer are incorporated, comprising the steps of:
maintaining a condition that the circuit surface side of the IC chip is curved in a concave shape; and
fixing the IC chip with the reinforcement structural member.

### BRIEF DESCRIPTION OF THE DRAWINGS

Fig. 1 is a drawing showing a layer construction of an IC-card according to the present invention.
Fig. 2 is a drawing showing a layer construction of an IC-card according to the present invention.
Fig. 3 shows a configuration of an IC module.
Figs. 4(a) to 4(b) show a configuration of an IC module.
Figs. 5(a) to 5(b) show a configuration of an IC module.
Fig. 6 shows a configuration of an IC module.
Fig. 7 shows a configuration of an IC module.
Fig. 8 shows a configuration of an IC module.
Figs. 9(a) and 9(b) show a configuration of an IC module.
Fig. 10 shows a configuration of an IC module.
Fig. 11 is a drawing showing one example of an IC card manufacturing method according to the present invention.

Fig. 12 is a perspective view showing an entire outline of a punching die apparatus.

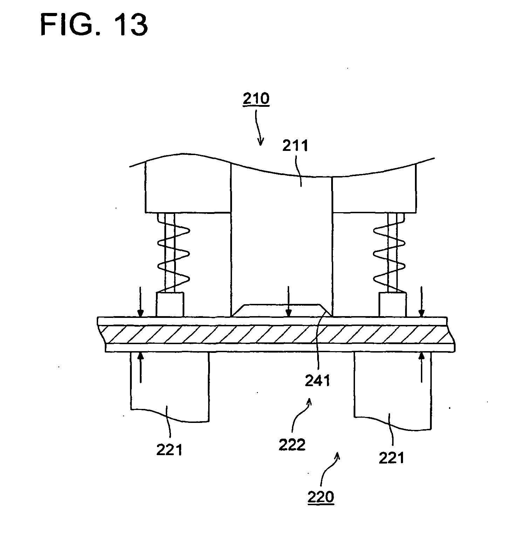

Fig. 13 is a front end view of a main part of the punching die apparatus.

### BEST MODE OF CARRYING OUT THE PRESENT INVENTION

The following describes the details of the IC card and the IC card production method of the present invention with reference to drawings, without the present invention being restricted thereto. The embodiments of the present invention show the most preferred forms of the invention, without the meaning of the terms in the present invention being restricted thereto.

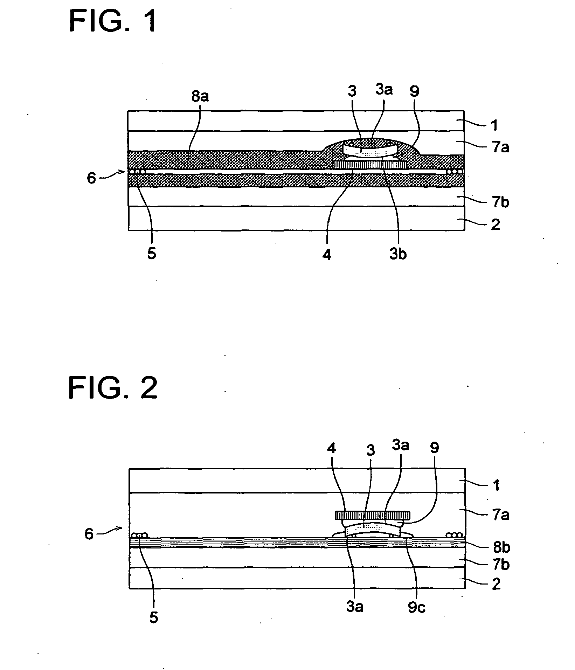

The IC card in Fig. 1 includes an IC chip 3, a reinforcement structural member 4 adjacent to the IC chip 3, and an IC module 6 containing an antenna 5 which are mounted between the first sheet member 1 and second sheet member 2. The IC module 6 is provided by filling with bonding agents 7a and 7b.

The IC chip 3, curved in a concave form toward the circuit surface 3a, is fixed to the reinforcement structural member 4 through the close contacting agent 9 on the surface 3b opposite to the circuit surface 3a. The IC module 6 has the antenna 5 arranged on the non-woven fabric sheet 8a. The IC chip 3 is arranged on the side of the first sheet member 1, and the reinforcement structural member 4 is arranged on the non-woven fabric sheet 8a on the side of the second sheet member 2.

The IC module 6 given in Fig. 2 has the antenna 5 mounted on the PET sheet 8b. The IC chip 3 is mounted on the PET sheet 8b on the side of the second sheet member 2. The reinforcement structural member 4 is provided on the side of the first sheet member 1. Further, the IC chip 3 is arranged on the PET sheet 8b through a conductive bonding agent 9c.

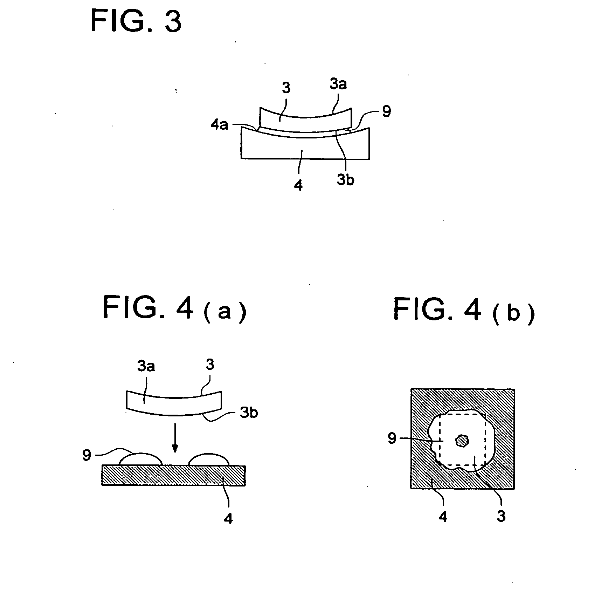

In the IC module 6 given in Fig. 3 (antenna 5 not illustrated for the sake of expediency), the IC chip 3, curved in a concave form toward the circuit surface 3a, is fixed to the reinforcement structural member 4 on the surface 3b opposite to the circuit surface 3a, wherein the reinforcement structural member 4 has a curve in the direction in which the IC chip 3 is curved.

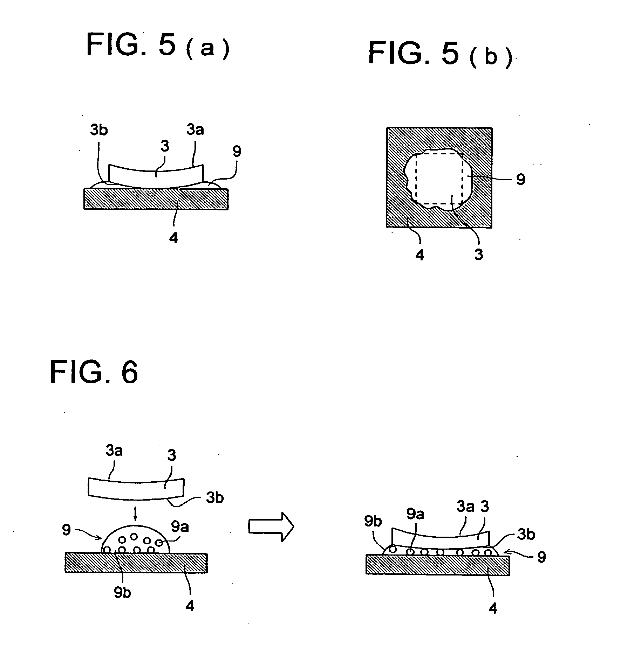

As shown in Figs. 1 through 3, before and after being brought into close contact with the reinforcement structural member 4, the IC chip 3 further curved in a concave form on the side of the circuit surface 3a is fixed to the reinforcement structural member 4. As shown in Figs. 4 and 5, the reinforcement structural member 4 is provided with an close contacting agent 9 in a ring form, and is fixed to the IC chip 3.

In the IC module 6 shown in Fig. 6, the IC chip 3 curved in a concave form toward the circuit surface 3a is fixed to the reinforcement structural member 4 through the close contacting agent 9 made of an elastic filler 9a and curable resin 9b on the surface 3b opposite to the circuit surface 3a of the IC chip 3.

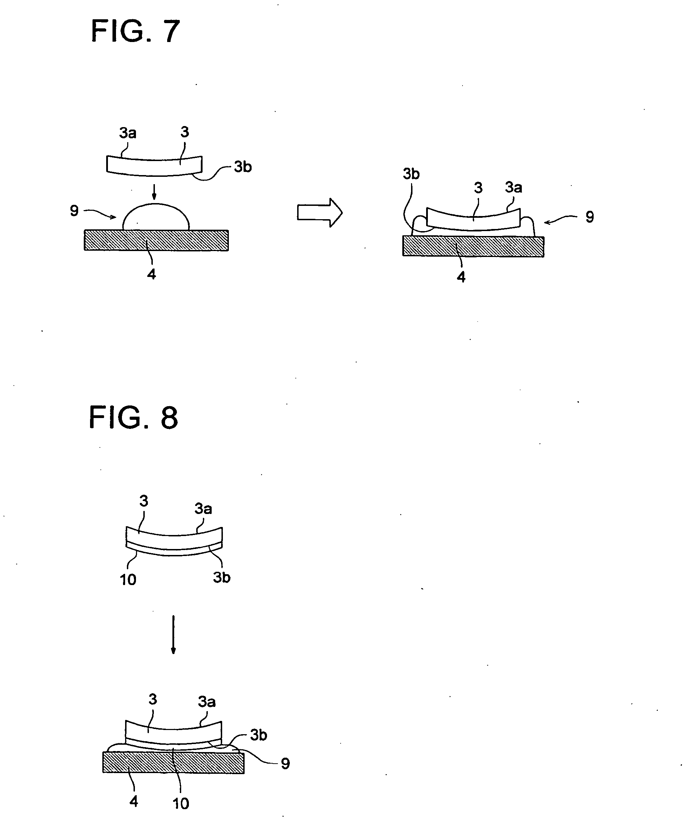

In the IC module 6 shown in Fig. 7, the IC chip 3 in a curved form is brought in close contact with the reinforcement structural member 4 through the close contacting agent 9, and the area of the close contacting agent 9 between the reinforcement structural member 4 and first sheet member 1 is greater than that of the IC chip.

Further, in the IC module 6 shown in Fig. 8, a retaining layer 10 for retaining the circuit surface side of the chip in a concave form in close contact with the IC chip 3 through the close contacting agent 9 is located on the surface 3b opposite to the circuit surface 3a of the IC chip 3.

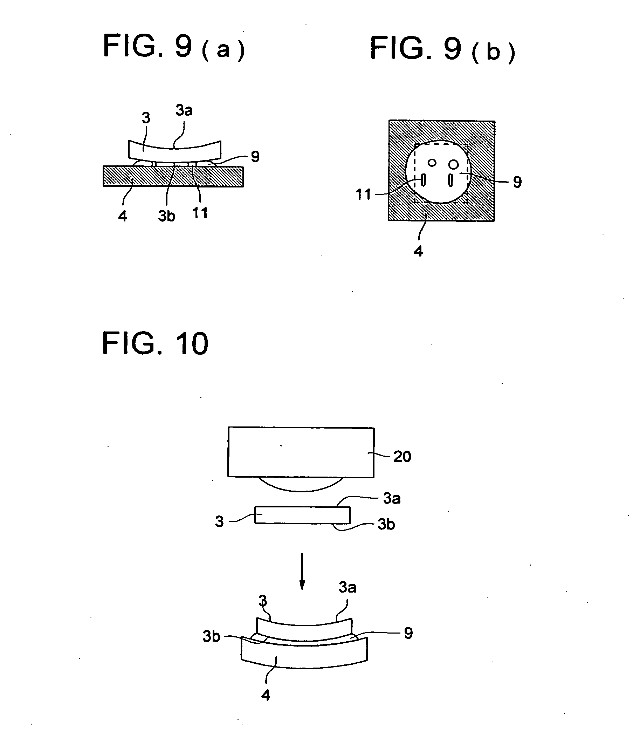

In the IC module 6 as shown in Fig. 9, even if the close contacting agent 9 is mixed with a bubble 11, the bubble 11 is crushed and disappears when brought in close contact with the IC chip 3 through the close contacting agent 9. The amount of the close contacting agent 9 exposed around the reinforcement structural member 4 can be reduced in proportion to the volume where the bubble 11 disappears.

In Figs. 1 through 9, the IC chip has a thickness of 25 µm or more without exceeding 110 µm, and the close contacting agent has a thickness of 3 µm or more without exceeding 50 µm. The IC chip 3 is fixed to the reinforcement structural member 4 through the close contacting agent 9 having a 2 % modulus of elasticity is 0.1 through 55 kg/mm².

The IC chip 3, curved in a concave form toward the circuit surface 3a, is fixed to the reinforcement structural member 4, but the IC chip 3 can be pushed by a pushing jig 20 curved in the same direction as that of the IC chip 3 so that it is fixed to the reinforcement structural member, as shown in Fig. 10. In this embodiment, the portion of the IC chip except for at least the outer periphery is pushed by the pushing jig 20.and the IC chip is fixed to the reinforcement structural member 4.

An image receiving layer is provided on at least one of the front and rear sides of the IC card, namely, one of the first sheet member 1 and second sheet member 2. This image receiving layer contains the personal identification information including at least the name and face images, and a writing layer that allows information to be written is provided on the other side.

If the IC chip 3 is thick, the card will be less smooth. This will produce variations in density, scratch or blur when the sublimation printing and heat-fusion printing method is used. To reduce the variations in density, scratch or blur, a thin-film IC chip 3 of the IC module 6 is produced. This relatively increases the stress for curving toward the side of the circuit surface 3a, due to the impact of the residual stress remaining on the circuit surface that can be ignored in the case of a thick-film IC chip 3, with the result that warpage tends to occur. If it is attached in a flat form against the force of warpage in an effort to solve this problem, durability will be reduced since warpage still remains on the side of the circuit surface 3a.

However, the durability in the direction of damaging the circuit will be improved substantially if the method of the present invention is used in combination, wherein the residual stress of the circuit surface is reduced to zero or is given to the side of the circuit surface 3a to be maintained there.

As described above, the method of the present invention improves the durability to withstand the impact due to an abruptly occurring stress and the repeated bending with repeated stress being applied, and solves the problems of the IC chip being cracked or the card being damaged due to repeated local loads, which may lead to an electrical operation failure. The method of the present invention brings about not only the improvement of the durability. It also improves the card surface qualities for storing the personnel information on a high level.

### <Measurement method of 2% module of elasticity>

As a measurement method of 2% module of elasticity, an adhesive of 500 µm thick was cured to prepare an adhesive sheet, and utilizing the adhesive sheet, tensile module of elasticity and tensile break point elongation were measured by use of Tensilon Universal Tester produced by Orientech Co., Ltd. according to ASTM D638.

### [First sheet member and second sheet member]

Examples of a support of the first sheet member and the second sheet member include single-layered sheets comprised of synthetic resin sheets of such as polyester resins such as polyethylene terephthalate, polybutylene terephthalate, and a polyethylene terephthalate/iso-phthalate copolymer; polyolefin resins such as polyethylene, polypropylene and polymethyl pentene; polyethylene fluoride type resins such as polyvinyl fluoride, polyvinylidene fluoride, polyethylene tetrafluoride and an ethylene/tetrafluoroethylene copolymer; polyamides such as 6-nylon, 6,6-nylon; vinyl polymers such as polyvinyl chloride, a vinyl chloride/vinyl acetate copolymer, an ethylene/vinyl acetate copolymer, an ethylene/vinyl alcohol copolymer, polyvinyl alcohol, vinylon; biodegradable resins such as biodegradable aliphatic polyester, biodegradable polycarbonate, biodegradable polylactic acid, biodegradable polyvinyl alcohol, biodegradable cellulose acetate and biodegradable polycaprolactone; cellulose-type resins such as cellulose triacetate and cellophane; acryl-type resins such as polymethyl methacrylate, polyethyl methacrylate, polyethyl acrylate and polybutyl acrylate; polystylene; polycarbonate; polyallylate and polyimide; or of paper such as wood free paper, thin leaf paper, grassine paper and sulfuric acid paper; and of metal foil; or multilayered sheets in which two or more sheets thereof are accumulated.

The thickness of a support of the invention is from 30 to 300 µm and preferably from 50 to 200 µm. In case of 50 µm or less, it may be problem that, because there may be thermal shrinkage at the time of laminating the first and the second sheet members together.

In the invention, a coefficient of thermal shrinkage is preferably not more than 1.2% in a longitudinal direction (MD) and not more than 0.5% in a width direction (TD) at 150 °C/30 min. Since it was difficult to register in the following cutting process and printing process due to thermal shrinkage having been caused by temperature incase that an adhesive was coated or laminated for production from both surface sides of the first support and the second support, it is preferred to caused no shrinkage of the supports by utilizing an adhesive, which adheres at low temperatures, and a support, having a coefficient of thermal shrinkage of not more than 1.2% in a longitudinal direction (MD) and not more than 0.5% in a width direction (TD) at 150 °C/30 min.

In the invention, preferably utilized is a support, which is prepared by blending with a white pigment to improve opacity and by being annealed to depress a thermal shrinkage percentage, having a thermal shrinkage percentage of not more than 1.2% in a longitudinal direction (MD) and not more than 0.5% in a width direction (TD) at 150 °C/30 min. The above-described after processes were proved to become difficult due to shrinkage of a support when a thermal shrinkage percentage is not less than 1.2% in a longitudinal direction (MD) and not less than 0.5% in a width direction (TD). Further, on the above-described support, adhesion enhancing treatment for improving adhesion in the post process or anti-static treatment for chip protection may have been provided. Concretely, U2 Series, U4 Series and UL Series manufactured by Teijin Dupont Film Co., Ltd.; Clisper G Series manufactured by Toyobo Co., Ltd.; and E00 Series, E20 Series, E22 Series, X20 series, X40 Series, E60 Series and QE Series manufactured by Toray Industries, Inc. can be suitably utilized.

The second support may be optionally provided with an image receiving layer and a cushion layer to form a face image of the card user. An image element is provided on the surface of a personal certification card base, and preferably includes at least one selected from a certifying identification image such as a face image, an attributing information image and format print.

For an image receiving layer, resins well known in the art can be utilized and examples include polyvinyl chloride resins, copolymer resins of vinyl chloride and other monomers (such as isobutylether and vinylpropionate), polyester resins, poly(metha)acrylate esters, polyvinylpyrrolidone, polyvinylacetal-type resins, polyvinylbutyral-type resins, polyvinylalcohol, polycarbonate, cellulose triacetate, polystyrene, copolymers of styrene and other monomer (such as acrylate ester, acrylonitrile and ehtylene chloride), vinyltolueneacrylate resins, polyurethane resins, polyamide resins, urea resins, epoxy resins, phenoxy resins, polycaprolactone resins, polyacrylonitrile resins and modified compounds thereof, and preferable are polyvinyl chloride resins, copolymers of vinyl chloride and other monomers, polyester resins, polyvinylacetal-type resins, polyvinylbutyral-type resins, copolymers of styrene and other monomers and epoxy resins.

As a material which forms the cushion layer of this invention, a light hardenable type resin and polyolefin described in Japanese Patent O.P.I. Publication No. 2001-1693 are desirable. For example, reisn having flexibility and low thermally conductivity such as polyethylene, polypropylene, an ethylene-vinyl acetate copolymer, an ethylene-ethyl acrylate copolymer, styrene-butadiene-styrene block copolymer, styrene-isoprene-styrene block copolymer, styrene-ethylene-butadiene-styrene block copolymer, styrene-hydrogenation isoprene-styrene block copolymer, and polybutadiene and a light hardenable resin may be suitable.

### <Cushion Layer>

Polyolefin is preferable as a material to form a cushion layer of the invention. For example, such as polyethylene, polypropyrene, an ethylene-vinyl acetate copolymer, an ethylene-ethylacrylate copolymer, a styrene-butadiene-styrene block-copolymer, a styrene-isoprene-styrene block-copolymer, a styrene-ethylene-butadiene-styrene block-copolymer, a styrene-hydrogenated isoprene-styrene block-copolymer, polybutadiene and a photo-curable resin; having flexibility and a low thermal conductivity are suitable. Concretely a cushion layer such as described in Japanese Patent Application No. 2002-222403 can be utilized.

A cushion layer referred in the invention means a soft resin layer, which is located between a support and an image receiving layer accepting an image, and functions to relax the effect of roughness caused by an electronic part such as an IC module.

The cushion layer is not particularly limited provided that it is of an embodiment locating a cushion layer between an image receiving layer and an electronic part, however, is specifically preferably formed being coated or laminated on one or both of the surfaces of a support.

### <Writing Layer>

A writing layer is a layer which is made to be writable on the back-side of an IC card. Such a writing layer can be formed, for example, by including inorganic fine particles of such as calcium carbonate, talc, diatomaceous earth, titanium oxide and barium sulfate in a film of a thermoplastic resin (e.g. a polyolefin series such as polyethylene, and various kinds of copolymers). It can be formed according to "a write-in layer" described in JP-A (Hereinafter, JP-A refers to Japanese Patent Publication Open to Public Inspection) No. 1-205155. The above-described writing layer is formed on the surface, on which plural layers are not accumulated, of a support.

### <Adhesive>

As a hot-melt adhesive for an IC card of the invention, ones commonly used can be uttilized. A main component of a hot-melt adhesive includes, for example, an ethylenevinylacetate copolymer (EVA) type, a polyester type, a polyamide type, a thermoplastic elastomer type, a polyolefin type, etc. However, in the invention, a card is liable to curl or a layer such as an image receiving layer for image formation by means of thermal transfer, being provided on a card surface and weak in a high temperature process, may be damaged. Further, when being laminated via adhesive, the base materials are preferably laminated at not higher than 80 °C, more preferably from 10 to 80 °C and furthermore preferably from 20 to 80 °C, in respect to problems in that base materials cause thermal shrinkage due to a high temperature lamination, resulting in poor dimensional and positional precision at the time of lamination. Among low temperature hot-melt adhesives, concretely, a reactive type hot-melt adhesive is preferable. A reactive type hot-melt adhesive (hereinafter, called as a reactive adhesive) is a adhesive of the type which resin hardens by absorbing moisture, after gluing by melting the resin. As a distinctive feature, since it has a cure reaction as compared with the usual hot melt, adhesion possibility time is long as it requires for it, and since softening temperature becomes high after adhesion, it is rich in durability and it may be suitable for processing at low temperature. As one example of reactive adhesive, there may be an adhesive in which isocyanate group containing polyurethane polymer at its molecule trailing end is contained as a main ingredient and this isocyanate group reacts with a water content so as to form a structure of cross linkage. As the reactive adhesive which can be used for this invention, TE030 and TE100 produced by Sumitomo 3M, Hybon 4820 produced by Hitachi Chemical polymer company, and Bondmaster 170 series produced by Kanebo NSC, Macroplast QR 3460 produced by Henkel may be listed.

As a reactive hot-melt adhesive, materials of a moisture curable type are disclosed in JP-A Nos. 2000-036026, 2000-219855, 2000-211278 and 2000-219855, and Japanese Patent Application No. 2000-369855. Photo-curable adhesives are disclosed in JP-A Nos. 10-316959 and 11-5964

Any of these adhesive may be used, and unlimited materials are preferably utilized in the invention.

A layer thickness of an adhesive, provided being in a range of the invention, is preferably from 10 to 600 µm, more preferably from 10 to 500 µm and furthermore preferably from 10 to 450 µm, based on a thickness including the electronic part.

### <Electronic Part (IC Module)>

An electronic part indicates an information recording member and concretely an IC module comprised of an IC-chip, which electrically records information of an electronic card user, and a coil-shaped antenna element connected thereto. An IC-chip is comprised of only a memory or of a microcomputer in addition thereto. Optionally, an electronic part may also include a condenser. The invention is not limited thereto, and an electronic part is not particularly limited provided that it is necessary for an information recording member.

An IC module is provided with an antenna; in case of being provided with an antenna pattern, it may be prepared by any method such as an electric-conductive paste printing process, a copper foil etching process and a wire welding process. As a printed board, a thermoplastic film such as polyester is utilized, and polyimide is advantageously used in case of high thermal-resistance being required. The bonding of an antenna pattern with an IC-chip is performed by any method commonly known such as a method utilizing electrical-conductive adhesives such as silver paste, copper paste, carbon paste, etc. (for example, EN-4000 Series manufactured by Hitachi Chemical Co., Ltd. and XAP Series manufactured by Toshiba Chemical Corp.); a method utilizing anisotropic electrical-conductive film (such as Anisolm manufactured by Hitachi Chemical Co., Ltd.); and a method applying solder bonding.

To avoid poor stability, such as disconnecting at bonding portions due to shear stress by adhesive flow, and damaging smoothness of the surface due to flow or cooling of an adhesive, caused by filling an adhesive layer resin after a part including an IC-chip is mounted on a predetermined position in advance, a part, to be enclosed in the adhesive layer on a board sheet in advance, is preferably prepared in a form of a porous resin film, a porous foaming resin film, a flexible resin sheet, a porous resin sheet or a non-woven fabric sheet. For example, a method described in Japanese Patent Application No. 11-105476 can be utilized.

For example, a non-woven fabric sheet member includes mesh-form fabric made of non-woven fabric, fabric of plain weave, twilled weave and satin weave. Further, fabric having piles called such as mocket, plushbelour, seal, velvet and suede can be utilized. Materials include fiber of combinations of one or not less than two kinds selected from synthetic resins of a polyamide type such as type 6-nylon, 66-nylon and 8-nylon, a polyester type such as polyethylene terephthalate, a polyolefin type such as polyethylene, polyvinyl alcohol, a polyvinilidene chloride type, a polyvinyl chloride type, an acryl type such as polyacrylonitrile, acrylamide and methacrylamide, a polyvinylidene cyanate type, a polyfluoroethylene type and polyurethane type; natural fibers such as silk, cotton, wool, a cellluose type and a cellulose ester type; regenerated fiber (rayon and actate) and aramide fiber. Among these fabric materials preferable are a polyamide type such as 6-nylon and 66-nylon, an acryl type such as polyacrylnitrile, acrylamide and methacrylamide, a polyester type such as polyethylene terephthalate, a cellulose type as a regenerated fiber, a cellulose ester type such as rayon and acetate and aramide fiber.

The total thickness of an electronic part is preferably from 10 to 500 µm, more preferably from 50 to 400 µm and furthermore preferably from 100 to 350 µm.

### <Close contacting agent>

The close contacting agent of the present invention permits unrestricted use of commonly employed resin materials the method of the present invention. To be more specific, it is possible to use the close contacting agent based on epoxy, urethane, silicon, cyanoacrylate, synthetic rubber such as nitrile rubber, ultraviolet cure resin, hot melt resin, anaerobic resin, cellulose and vinyl acetate. These close contacting agent can be used independently or in combination. An elastic epoxy close contacting agent is preferably used. The resin composition formed by combination between epoxy resin and mercaptan based curing agent, disclosed in the Official Gazette of Japanese Patent Tokkaisho 63-63716 has been used as the elastic epoxy close contacting agent to ensure good curability at low temperatures. The epoxy resin composition formed by combination with the complex cyclic diamine curing agent has also been used. The epoxy resin formed by combination with aromatic polyamine curing agent has been used to increase the strength.

To improve the working environment characteristics, bondability with the support member and bonding stability, the epoxy resin composition has been used, which is formed by combination of bisphenol based epoxy resin, and (C) polyamideamine (D) aromatic modified amine and (E) aliphatic modified polyamine, as amine based curing agent, as disclosed in the Official Gazette of Japanese Patent Tokkaihei 10-120764. An epoxy resin, characterized by high curing speed, formed by combination of the epoxy resin and amineimide compound based curing agent is disclosed in the Official Gazette of Japanese Patent Tokkai 2000-229927. The Official Gazettes of Japanese Patents Tokkaihei 6-87190 and 5-295272 show the case of using a special modified silicone prepolymer as a curing agent, and disclose the material characterized by improved flexibility of the resin.

The elastic epoxy close contacting agent that can be used in the present invention includes Cemedine EP-001 by Cemedine Co., Ltd., 3950, 3951 and 3952 of 3950 Series by Threebond Co., Ltd., MOS07 and MOS10 of MOS Series by Konishi Co., Ltd., Urtite 1540 of Urtite 1500 Series by Toho Chemical Industry Co., Ltd., etc.

The film thickness of the close contacting agent is preferably 1 through 100 µm in terms of the value including the thickness of the electronic parts, more preferably, 1 through 70 µm, still more preferably, 3 through 50 µm.

The close contacting agent resin of the present invention preferably has a viscosity of 1000 through 35,000 cps at 23 degrees Celsius, more preferably 3000 through 35000 cps. If the viscosity is below 1,000 cps, the liquid will flow away when the IC chip and reinforcement structural member are brought in close contact with each other. This will cause a film thickness control failure and irregular film thickness. If the viscosity is over 35,000, a coating streak and bubble will be produced at the time of production. This will cause reduce the degree of adhesion.

The resin property of 500 µm of the close contacting agent used in the present invention subsequent to curing is preferably 0.1 through 55 (kg/mm²) at 2% elastic modulus (kg/mm²). If it is less than 0.1 or more than 55 (kg/mm²), the stress and deformation of the IC chip or reinforcement structural member will be concentrated on the IC chip. This will reduce the durability and raises a problem.

The close contacting agent is applied to the reinforcement structural member and IC chip by potting, coating, jetting or printing without particular restriction. If it is applied by potting, it is preferred to increase the number of the potting nozzles. If it is applied by coating, smooth coating is preferred. When the reinforcement structural member is fixed to the IC chip, uniform application of the close contacting agent is preferred. In the present invention, the area of the close contacting agent provided between the curved IC chip and reinforcement structural member is greater than that of the IC chip.

In the present invention, additives can be supplied Especially, elastic particles are preferably contained in the close contacting agent. The materials that can be added to the close contacting agent include wax, thermosetting resin, inorganic fine particles, leveling agent, rubber elastic particles, thermosetting elastomer, thermosetting resin, pressure sensitive close contacting agent, curing agent, curing catalyst, flow leveling agent, flat particles, needle-shaped particles and others. These substances can be mixed.

Addition of elastic particles is preferred because it reduces the stress applied to the IC chip in the process of fixing the reinforcement structural member, removes the residual strain and improves durability. The stress applied to the IC chip can be reduced and durability can be improved even after a card has been formed.

Such flat substances as mica, talc, laminated silicate and silver halide can be used as flat particles.

The flat silica compound as a flat substance refers to the laminated silicate, namely, flat silicate containing alkali, alkali earth metal, aluminum and others. The examples are karyon mineral, mica clay mineral and smectite. The karyon mineral is exemplified by karyonite, dickite, nakhlite, halloysite and serpentinite. The mica clay mineral includes pyroferrite, talc, muscovite, swelling synthetic fluorine mica, sericite and chlorite. The smectite includes smectite, vermiculite and swelling synthetic fluorine vermiculite. The smectite includes naturally occurring and synthetic ones. The examples of naturally occurring ones are montmorillonite and beidellite. They can be obtained in the form of bentonite and the clay called acid clay. Examples of the synthetic smectite are Lucentite SWN (hereinafter referred to as "STT=1") and Lucentite SWF (2 through 5 wt% of fluorine) (hereinafter referred to as "STT-2) by Corpchemical Co., Ltd.

The preferred amount of the flat particles used in the present invention is 0.10 through 0.90, particularly preferably 0.2 through 0.8, in terms of dry weight ratio, with respect to the binder of the layer where it is to be added.

The examples of needle-shaped particles are hexagonal ferrite such as barium ferrite and strontium ferrite. The needle-shaped particle can be a fabric piece having a high modulus of elasticity such as aramid fiber.

If required, other fine particles can also be used in combination. Other fine particles that can be preferably used are various types of inorganic oxides, carbides, nitrides and borites. They are exemplified by silica, alumina, titania, zirconia, barium titanate, aluminum titanate, strontium titanate, magnesium titanate, calcium titanate, zinc oxide, chromium oxide, cerium oxide, antimony oxide, tungsten oxide, tin oxide, tellurium oxide, manganese oxide, boron oxide, silicon carbide, boron carbide, titanium carbide, silicon nitride, titanium nitride and boron nitride.

The examples of the tackiness polymer include: silicones of a mixture between a silicone rubber such as polydimethyl siloxane and polydiphenyl siloxane; and a silicone resin such as polysiloxane containing the trimethylsilyl group or triphenylsilyl group; polyesters; polyurethanes; polyethers; polycarbonates; polyvinylethers; polyvinyl chlorides; polyvinyl acetates; polyisobutylenes; and other polymer other than acryl-based ones. The examples further include: acryl, acrylonitrylbutadien (NBR), Random type styrene butadiene rubber, butyl rubber, isopyrene rubber (IR), butadiene rubber (BR), ethylenepropylene rubber (EPM), ethylenepropylenedien rubber (EPDM), urethane rubber, styrene isopyrene styrene rubber (SIS), styrene ethylene butadiene styrene block rubber (SEBS) and styrene butadiene block rubber. These substances can be used. The resin having a low thermal softening point, such as acryl polymer mainly made up of alkylacrylate having a low glass-transition temperature, is preferably used to ensure that the polymer as a simple substance will exhibit adequate pressure sensitive bondability.

### <Reinforcement structural member>

In the present invention, a reinforcement structural member is fixed to the IC chip to improve the IC chip durability. The reinforcement structural member of the present invention is preferred to have a high degree of mechanical strength. When the reinforcement structural member thickness is increased to ensure a high degree of mechanical strength, the card thickness will be increased and printability on the surface will deteriorate. Thus, the reinforcement structural member is preferably made of highly rigid materials, such as metal, ceramic, carbon fiber, glass fiber, aramid fiber and highly elastic resin. One of the materials selected from the above or a composite material made of more than one of such selected materials can be used. Especially, the material having a Young's modulus of 100 GPa or more is preferably used as the main material. The thickness is preferably 10 through 300 µm, preferably 30 through 200 µm, more preferably 50 through 150 µm. The reinforcement structural member can be made in any form. In the present invention, it is preferred to use a reinforcement structural member having the curved surface conforming to the curvature of the chip. The reinforcement structural member can be made of a single member, but is more preferably made of a plurality of members because stress distribution on the chip is ensured. When it is made of a plurality of members, lamination of the members characterized by a high degree of mechanical strength is preferred.

### <Method to Provide Electronic Part having Prescribed Thickness between First Support and Second Support>

As a manufacturing method to provide a predetermined electronic part between the first support and the second support of the invention, a thermal lamination method, an adhesive lamination method and an injection molding method are well known and any of the methods can be utilized. Format printing or information recording may be performed before or after the first support and the second support being laminated, and it can be formed by any method such as off-set printing, gravure printing, silk printing, screen printing, intaglio printing, letterpress printing, an ink jet method, a sublimation transfer method, an electrophotographic method and a thermal fusion method.

A manufacturing method of an IC card of the invention is comprised of at least a process in which an adhesive member, being in a state of solid or viscous body at ordinary temperature and softened in a heated state, is provided on a support for an IC card, a process in which an electronic part is arranged on the support, a process in which a support for the front surface provided with an adhesive member is arranged so as to cover the electronic part on the support, and a process in which a support, an electronic part and a support for the front surface are laminated together; and lamination is preferably performed.

The adhesive member being a solid body or a viscous body and softened in a heated state is preferably prepared by a method in which an adhesive itself is formed in a sheet-form, or by a method in which an adhesive itself is melt by heat or at ordinary temperature and laminated by means of an injection molding method.

Temperature of enabling to adhere an electronic part predetermined between the first support and the second support is preferably not higher than 80 °C, more preferably from 0 to 80 °C and furthermore preferably from 20 to 70 °C. A cooling process is preferably provided after the lamination to reduce such as warp of a support. Cooling temperature is preferably not higher than 70 °C, more preferably from -10 to 70 °C and furthermore preferably from 10 to 60 °C.

At the time of lamination, to enhance smoothness of a base surface and adhesion property of an electronic part predetermined between the first support and the second support, they are preferably subjected to heating and pressing, and preferably manufactured by such as an up-and-downward pressing and lamination method. Further, it is preferred to avoid utilizing rolls which provides nearly linear contact and unreasonable bending force with even a slight shift, and to adopt a planar-press type, taking cracking of IC-parts into consideration. The heating is preferably performed at from 10 to 120° C and more preferably from 30 to 100° C. The press is preferably performed at from 0.1 to 300 kgf/cm² and more preferably at from 0.1 to 100 kgf/cm². When the pressure is higher than this, an IC-chip may be collapsed. The time for heating and pressing is preferably from 0.1 to 180 sec. and more preferably from 0.1 to 120 sec.

A laminated sheet or a continuously coated lamination roll, prepared as a continuous sheet by an adhesive-lamination method or a resin injection method described above, may be recorded with certifying identification images and bibliographic items after being allowed to stand for a time equal to a predetermined curing time of an adhesive; thereafter, may be shaped into a prescribed card size. As methods for shaping into a prescribed card size, such as a stamping method and a cutting method are mainly selected.

### <General Description on Image Forming Method of Image Recording Element>

An image recording element of an IC card according to the invention is provided with an image element of at least one selected from a certifying identification image such as a face image, an attribute information image and a format printing is formed on a an image or printing surface side of a substrate.

A face image is generally a full-colored image having tone, and is prepared, for example, by a sublimation thermal transfer recording method or a silver halide color photographic method. A letter information image, comprises a binary image, and is formed, for example, by such as a fusion thermal transfer recording method, a sublimation thermal transfer recording method, a silver halide color photographic method, electrophotographic method, or an ink-jet method.

In the invention, it is preferable to record a certifying identification image such as a face image and an attribute information image by a sublimation thermal transfer recording method. Attribute information include a name, an address, a birth date, a license, etc., and are recorded, usually as letter information, generally by means of a fusion thermal transfer recording method. A format printing or information recording may also be performed, and this can be formed by any method such as offset printing, gravure printing, silk printing, screen printing, intaglio printing, letterpress printing, an ink-jet method, a sublimation transfer method, an electrophotographic method and a thermal fusion method.

Further, for the purpose of preventing forgery and alternation, an optical variable device described below such as a hologram and a fine structure tint may be adopted. A layer to prevent forgery and alternation is optionally selected from a printed matter, a hologram, a bar cord, a matte pattern, a fine structure tint, a ground tint and a roughened pattern, and is comprised of a visible light absorbing colorant, a UV absorbent, an infrared absorbent, a fluorescent brightener, a metal evaporated layer, a glass evaporated layer, a bead layer, an optical variable element layer, a pearl ink layer and a scaly pigment layer.

### [Sublimation image forming method]

An ink sheet for sublimation thermal transfer recording of a sublimation image forming method can be composed of a support and an ink layer formed thereon containing sublimation dyes.

### -Support-

As a support, there is no specific limitation, and those well known in the art, provided being superior in dimensional stability and resistant against heat at the time of recording with a thermal head, can be utilized.

### -Sublimation Dye Containing Ink Layer-

The sublimation dye containing ink layer described above basically contains a sublimation dye and a binder.

The above-described sublimation dye includes cyan dyes, magenta dyes and yellow dyes.

The cyan dyes include naphthoquinone type dyes, anthraquinone type dyes and azomethine type dyes described in such as JP-A Nos. 59-78896, 59-227948, 60-24966, 60-53563, 60-130735, 60-131292, 60-239289, 61-19396, 61-22993, 61-31292, 61-31467, 61-35994, 61-49893, 61-148269, 62-191191, 63-91288, 63-91287 and 63-290793.

The magenta dyes include anthraquinone type dyes, azo type dyes and azomethine type dyes described in such as JP-A Nos. 59-78896, 60-30392, 60-30394, 60-253595, 61-262190, 63-5992, 63-205288, 64-159 and 64-63194.

The yellow dyes include methine type dyes, azo type dyes, quinophthalone type dyes and anthraisothiazole type dyes described in such as JP-A Nos. 59-78896, 60-27594, 60-31560, 60-53565, 61-12394 and 63-122594.

Specifically preferable sublimation dyes are azomethine dyes obtained by coupling reaction of compounds having a closed-chain type or open-chain type active methylene group, with oxidants of p-phenylenediamine derivatives or those of p-aminophenol derivatives; and indoaniline dyes obtained by coupling reaction of phenol or naphthol derivatives with oxidants of p-phenylenediamine derivatives or those of p-aminophenol derivatives.

Further, when a metal ion containing compound is included in an image receiving layer, it is preferable to include a sublimation dye that forms a chelate upon reaction with the metal ion containing compound, in a sublimation dye including ink layer. Examples of the chelate forming sublimation dyes include cyan dyes, magenta dyes and yellow dyes, forming a chelate of at least bidentate, described in JP-A Nos. 59-78893 and 59-109349, Japanese Patent Application Nos. 2-213303, 2-214719 and 2-203742. Preferable sublimation dyes capable of forming a chelate can be represented by the following general formula:

X₁-N=N-X₂-G

where, X₁ represents an aromatic carbon ring, in which at least one ring is composed of 5 to 7 atoms, or an atomic group necessary to complete a heterocyclic ring, provided that at least one of the adjacent positions to carbon atoms which bond to the azo bond is a carbon atom substituted by a nitrogen atom or a chelating group; X₂ represents an heterocyclic ring, in which at least one ring is composed of 5 to 7 atoms, or an aromatic carbon ring; and G represents a chelating group.

Any sublimation dyes contained in the sublimation dye containing ink layer above described, may be any of a yellow dye, a magenta dye and a cyan dye when an image to be formed is monocolor, and any two or more dyes out of three dyes above described or other sublimation dyes may be contained depending on the color of an image to be formed. The using amount of sublimation dyes described above generally from 0.1 to 20 g and preferably 0.2 to 5 g, based on 1 m² of a support.

A binder for an ink layer is not specifically limited, and those well known in the art can be used.

Further, in the aforementioned ink layer, various kinds of additives well known in the art can be suitably added. An ink sheet for sublimation thermal transfer recording can be prepared in such a manner that ink layer coating solution, which has been prepared by dispersing or solving various ink layer components described above, is coated on a support and then dried. The thickness of thus prepared ink layer is generally from 0.2 to 10 µm and preferably from 0.3 to 3 µm.

### EXAMPLES

The invention will be described below, based on examples, however the embodiment of the invention is not limited thereto. Hereinafter, "part(s)" represents "part(s) by weight".

### <Preparation of Adhesive>

### Adhesive

Macroplast QR3460 (2% elastic-modulus 15kg/mm2, moisture-curable adhesive), manufactured by Henkel Co. was used.

### [Production of IC module]

### (Close contacting agent)

### Close contacting agent 1

Two liquid hardening type elastic epoxy adhesive: manufactured by Toho Chemical Industry limited company

Main agent using Ultait 1540 set (after-hardening 500-micrometer fracture elongation: 176%, 2% elastic-modulus: 0.4 kg/mm², viscosity: 15000mps) and a hardener were used.

### Close contacting agent 2

- Macroplast QR3460 (moisture-curable adhesive), manufactured by Henkel Co. 90 parts
- Silicone resin powder (Tosspearl 150; made by GE Toshiba Silicones Co., Ltd.) 10 parts

The above-mentioned compositions were stirred with a homogenizer for 60 minutes at the temperature of 150 degrees C, thereby Adhesive 2 was produced. (2% elastic-modulus: 30 kg/mm²)

### Close contacting agent 3

- Two liquid hardening type elastic epoxy adhesive: manufactured by Toho Chemical Industry limited company Ultait 1540 set 90 parts
- Silicone resin powder (Tosspearl 150; made by GE Toshiba Silicones Co., Ltd.) 10 parts

The above-mentioned compositions were stirred with a homogenizer for 60 minutes, thereby Adhesive 3 was produced. A hardener was added right before use. (2% elastic-modulus: 1 kg/mm²)

### Close contacting agent 4

Main agent using Threebond main agent 2002H / hardener 2105F (after-hardening 500-micrometer fracture elongation: 15%, 2% elastic-modulus: 0.05 kg/mm² viscosity: 65000mps) and a hardener were used.

### Adhesive 5

Aronalpha GEL-10 (2% module of elasticity is 60 kg/mm², manufactured by Toagosei Co., Ltd.) was used.

### IC module 1;

On a plate-form reinforcement plate of 120 µm thick and 4 x 4 mm square comprised of SUS 301, Close contacting agent 1 was subjected to potting on the opposite side of a circuit surface side and was brought in close contact with an opposite surface side to a circuit surface side of an IC-chip of 50 µm thick and 3 x 3 mm square which was curved beforehand toward the circuit plain side, thereafter an wire-type antenna was formed and was bonded to the IC-chip. Next, an IC module was sandwiched from both sides with a non-woven sheet comprised of polyethylene terephthalate fiber, thereby IC module 1 was prepared. The average layer thickness of the close contacting agent was 5 µm and the area of it was expanded to be larger than the IC-chip (Fig. 1).

Incidentally, the thickness of IC-chip in the present invention means a thickness in the case that the IC-chip was pierces with a straight line along the radius of curvature of a circuit surface side or an opposite surface side of the circuit surface (if the circuit surface is not curved, the IC-chip was pierces with a straight line along a normal line of a circuit surface side or an opposite surface side of the circuit surface).

### IC Module 2;

An IC-chip of 65 µm thick and 3 x 3 mm square which was curved beforehand toward a circuit surface side was adhered in a bump by use of an electro-conductive adhesive of 20 µm thick on a support having a thickness of 38 µm on which an antenna pattern had been formed by etching, and a plate-form reinforcement structural member of 120 µm thick and 4 x 4 mm square comprised of SUS 301 was adhered on the opposite side to a circuit surface with Close contacting agent 1 of 10 µm thick, thereby IC module 2 was prepared (Fig. 2).

### IC module 3;

On a reinforcement plate of 120 µm thick and 4 x 4 mm square comprised of SUS 301 which was shaped in a concave form on a IC-chip attached surface side, Close contacting agent 1 was subjected to potting on the opposite side of a circuit surface side and was brought in close contact with the opposite surface side of a circuit surface side of an IC-chip of 50 µm thick and 3 x 3 mm square which was curved beforehand in a concave form on the circuit plain side, thereafter an wire-type antenna was formed and was bonded to the IC-chip. Next, an IC module was sandwiched from both sides with a non-woven sheet comprised of polyethylene terephthalate fiber, thereby IC module 3 was prepared (Fig. 3).

### IC module 4;

On a bowl-shaped reinforcement plate (Fig. 2) of 120 µm thick and 4 x 4 mm square comprised of SUS 301, Close contacting agent 1 was subjected to potting on the opposite side of a circuit surface side and was brought in close contact with the opposite surface side of a circuit surface side of an IC-chip of 50 µm thick and 3 x 3 mm square, which was curved beforehand toward the circuit plain side, by the used of a hemisphere-shaped special tool having a radius of curvature smaller that that of the circuit surface side and was hardened with heating, thereafter an wire-type antenna was formed and was bonded to the IC-chip. Next, an IC module was sandwiched from both sides with a non-woven sheet comprised of polyethylene terephthalate fiber, thereby IC module 3 was prepared (Fig. 10).

### IC module 5;

On a plate-form reinforcement plate of 120 µm thick and 4 x 4 mm square comprised of SUS 301, Close contacting agent 1 was subjected to potting in a form of a ring on the opposite side of a circuit surface side and was brought in close contact with the opposite surface side of a circuit surface side of an IC-chip of 50 µm thick and 3 x 3 mm square which was curved beforehand toward the circuit plain side, thereafter an wire-type antenna was formed and was bonded to the IC-chip. Next, an IC module was sandwiched from both sides with a non-woven sheet comprised of polyethylene terephthalate fiber, thereby IC module 4 was prepared(Fig. 4).

### IC module 6;

On a plate-form reinforcement plate of 120 µm thick and 4 x 4 mm square comprised of SUS 301, Close contacting agent 2 was subjected to potting at 120 °C on the opposite side of a circuit surface side and was brought in close contact with the opposite surface side of a circuit surface side of an IC-chip of 50 µm thick and 3 x 3 mm square which was curved beforehand toward the circuit plain side, thereafter an wire-type antenna was formed and was bonded to the IC-chip. Next, an IC module was sandwiched from both sides with a non-woven sheet comprised of polyethylene terephthalate fiber, thereby IC module 6 was prepared(Fig. 6).

### IC module 7;

On a plate-form reinforcement plate of 120 µm thick and 4 x 4 mm square comprised of SUS 301, Close contacting agent 3 was subjected to potting on the opposite side of a circuit surface side and was brought in close contact with an opposite surface side to a circuit surface side of an IC-chip of 50 µm thick and 3 x 3 mm square which was curved beforehand toward the circuit plain side, thereafter an wire-type antenna was formed and was bonded to the IC-chip. Next, an IC module was sandwiched from both sides with a non-woven sheet comprised of polyethylene terephthalate fiber, thereby IC module 7 was prepared (Fig. 6).

### IC module 8;

IC module 8 was prepared wit the same manner of IC module 1 except that the thickness of IC-chip was made 25 µm. IC module 9;

IC module 9 was prepared wit the same manner of IC module 1 except that a UV hardenable type resin was provided to the reverse side of the chip.

After providing Aronix UV-3300 (made by the Toagosei chemistry company) in a half-hardening state so as to be 5 µm, hardening and close-contacting were conducted by scanning with light from a high-pressure mercury lamp of a light irradiation source of 80 w/cm2 with a light irradiation distance of 10cm, and an irradiation mode of 3 cm/second (Fig. 8).

### IC module 10;

IC module 10 was prepared wit the same manner of IC module 1 except that the thickness of IC-chip was made 130 µm and the average thickness of Close contacting agent was made 60 µm.

### IC module 11;

IC module 11 was prepared wit the same manner of IC module 1 except that Close contacting agent 4 was used.

### IC module 12;

IC module 12 was prepared wit the same manner of IC module 1 except that a plate-shaped IC-chip of 50 µm thick was curved toward a circuit plane side and Close contacting agent 4 was used.

### IC module 13;

IC module 13 was prepared wit the same manner of IC module 1 except that a flat plate IC-chip of 180 µm thick and Close contacting agent 5 was used.

### IC module 14;

IC module 14 was prepared wit the same manner of IC module 1 except that a potting amount of Close contacting agent 1 was made half and a flat plate IC-chip of 180 µm thick was used. An average layer thickness of the close contacting agent layer formed by the adhesive was 2 µm and an area of it was smaller than the IC-chip (Fig. 9).

### IC module 15;

IC module 15 was prepared wit the same manner of IC module 1 except that IC-chip was made a chip of 130 µm thick which was curved toward a circuit plane side and the opposite side plane of a circuit plane was brought in a flat plane shape in close contact such that a circuit plane of a 3 x 3 mm square IC-chip became a flat.

### <Example 1>

### [Production of IC card]

This is an example of an accumulated layer configuration of an IC card and a personal certification card according to the invention.

### Support 1;

A white polyester sheet having a thickness of 125 µm was used as the obverse side support and the reverse side support.

### <Preparation of obverse surface support>

### <Support 1>

The first image receiving layer coating solution, the second image receiving layer coating solution and the third image receiving layer coating solution, having the compositions described below, were coated and then dried, in this order, on a corona discharge treated surface of a 125 µm obverse surface support sheet (the second sheet member) to be accumulated so as to make each thickness of 0.2 µm, 2.5 µm and 0.5 µm. Thus an image receiving layer was formed.

### <First Image Receiving Layer Coating Solution>

| | |
|---|---|
| Polyvinyl butylal resin (Eslec BL-1, manufactured by Sekisui Chemical Co., Ltd.) | 9 parts |
| Isocyanate (Coronate HX, manufactured by Nippon Polyurethane Kogyo Co., Ltd.) | 1 part |
| Methyl ethyl ketone | 80 parts |
| Butyl acetate | 10 parts |

### <Second Image Receiving Layer Coating Solution>

| | |
|---|---|
| Polyvinyl butyral resin (Eslec BX-1, manufactured by Sekisui Chemical Co., Ltd.) | 6 parts |
| Metal ion containing compound (Compound MS) | 4 part |
| Methyl ethyl ketone | 80 parts |
| Butyl acetate | 10 parts |

### <Third Image Receiving Layer Coating Solution>

| | |
|---|---|
| Polyethylene wax (Hitech E1000, manufactured by Toho Chemical Industry Co., Ltd.) | 2 parts |
| Urethane modified ethylene acrylic acid copolymer (Hitech S6254, manufactured by Toho Chemical Industry Co., Ltd.) | 8 parts |
| Methyl cellulose (SM15, manufactured by Shin-Etsu Chemical Co., Ltd.) | 0.1 part |
| Water | 90 parts |

### <Format Printing>

A logogram and OP varnish were printed successively by a resin letterpress method.

### <Preparation of reverse surface support>

### <Preparation of Writing Layer>

The first writing layer coating solution, the second writing layer coating solution and the third writing layer coating solution, having the compositions described below, were coated and then dried, in this order, on a corona discharge treated surface of the 125 µm reverse surface support sheet (the first sheet member) described above to be accumulated so as to make each thickness of 5 µm, 15 µm and 0.2 µm. Thus a writing layer was formed.

### <First Writing Layer Coating Solution>

| | |
|---|---|
| Polyester resin (Vilon 200, manufactured by Toyobo Co., Ltd.) | 8 parts |
| Isocyanate (Coronate HX, manufactured by Nippon Polyurethane Kogy Co., Ltd.) | 1 part |
| Carbon black | a slight amount |
| Titanium dioxide particles (CR80, manufactured by Ishihara Sangyo Kaisha Ltd.) | 1 part |
| Methyl ethyl ketone | 80 parts |
| Butyl acetate | 10 parts |

### <Second Writing Layer Coating Solution>

| | |
|---|---|
| Polyester resin (Vilonal MD1200, manufactured by Toyobo Co., Ltd.) | 4 parts |
| Silica | 5 parts |
| Titanium dioxide particles (CR80, manufactured by Ishihara Sangyo Kaisha Ltd.) | 1 part |
| Water | 90 parts |

### <Third Writing Layer Coating Solution>

| | |
|---|---|
| Polyamide resin (Sunmide 55, manufactured by Sanwa Chemical Ind. Co., Ltd.) | 5 parts |
| Methanol | 95 parts |

A center line mean roughness of the writing layer obtained was 1.34 µm.

### <Preparation of Sheet for IC card>

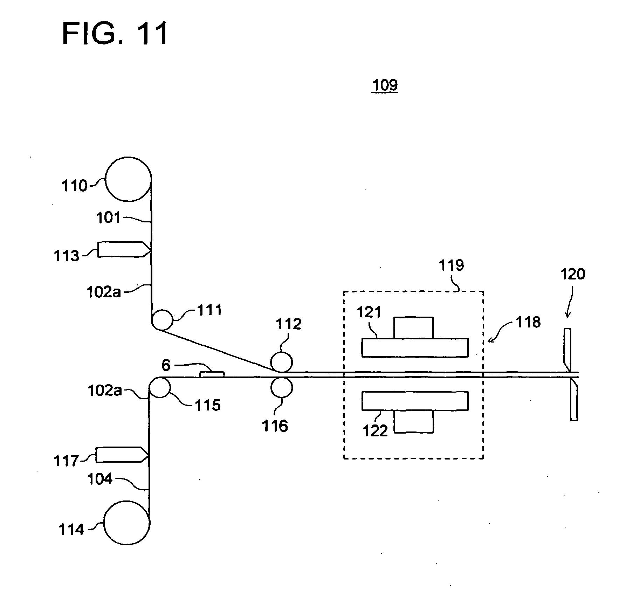

Fig. 11 shows an example of a producing apparatus of an IC card according to the invention. IC card producing apparatus 109 is equipped with a sending-out axis 110 which sends out first sheet member 101, and first sheet member 101 being sent out from sending-out axis 110 is fed being hanged through guide roller 111 and drive roller 112. Applicator coater 113 is arranged between sending-out axis 110 and guide roller 111. Applicator coater 113 coats adhesive 102a on a sheet at a predetermined thickness.

Further, IC card producing apparatus 100 is equipped with sending-out axis 114 which sends out the first sheet member 104, and the first sheet member 104 being sent out from sending-out axis 114 is fed being hanged through guide roller 115 and drive roller 116. Applicator coater 117 is arranged between sending-out axis 114 and guide roller 115. Applicator coater 117 coats adhesive 102b on a sheet at a prescribed thickness.

First sheet member 101 and first sheet member 104, on which an adhesive having been coated, are brought in contact to be transported along transporting passage 118 from the state of facing to each other while being separated. IC module 6 is inserted at the position where first sheet member 101 and first sheet member 104 are facing to each other while being separated.

IC module 6 is fed as an unite, or as plural units in a sheet-form or a roll-form. In transport passage 118 of IC card producing apparatus 100, heat laminator section 119 and cutting section 120 are arranged along a transport direction of first sheet member 101 and first sheet member 104. A heat laminator is preferably a vacuum heat laminator. Further, protective film supply sections may be provided before heat laminator section 119 and are preferably arranged over and under transport passage 118 facing to each other. Heat laminator section 119 is constituted of heat laminator over-type 121 and heat laminator under-type 122 arranged over and under transport passage 118 facing to each other. Heat laminator over-type 121 and heat laminator under-type 122 are set to be shiftable in a direction of contacting with and separating from each other. The sheet material is cut into a prescribed size after passing through heat laminator section 119.

### <Preparation of Sheet 1 for IC card>

A card producing apparatus of Fig. 11 was utilized and the above-described reverse side support and the obverse side support having an image receiving layer are utilized as the first sheet member and the second sheet member.

Adhesive 1 was coated on the obverse surface support having an image receiving layer by use of T dies so as to make a thickness of 760 µm; IC module 1 was mounted such that the circuit plane became the reverse surface side, and then sandwiched by up and down sheets; and the resulting configuration was laminated for 1 minute at 70 °C to prepare sheet 1 for an IC card. Thus produced sheet for an IC card has a thickness of 760 µm. The sheet after preparation was kept for 7 days under an environment of 25 °C and 50% RH.

### [Punching]

A sheet for an IC card thus prepared was subjected to a stamping process by use of the following IC card stamping dies apparatus.

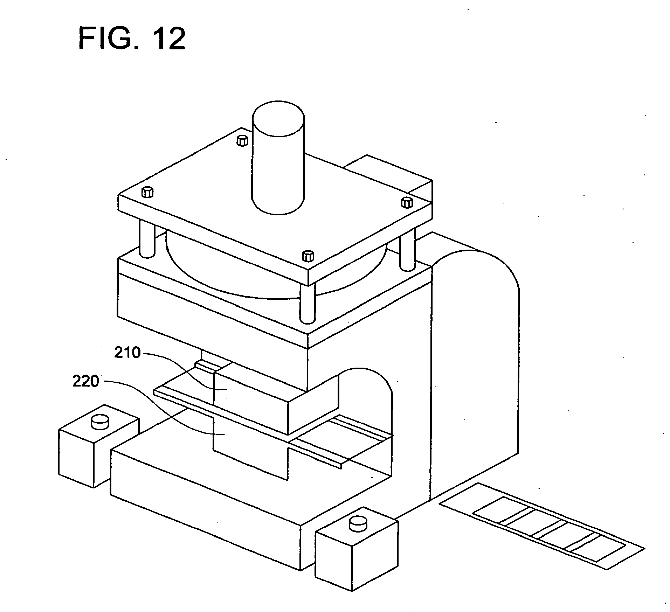

Fig. 12 is a brief oblique view drawing of a stamping dies apparatus and Fig. 10 is a front end view drawing of a main portion of a stamping dies apparatus. The stamping dies apparatus provided with a stamping dies having over blade 210 and under blade 220. Herein, over blade 210 includes stamping punch 211 provided with escape 241 at the inside of an outer edge and under blade 220 has stamping dies hole 222. An IC card having the same size as that of dies hole 222 is stamped by descending stamping punch 211 into dies hole provided at the center of stamping dies 221. Further, for this purpose, the size of stamping punch 211 is slightly smaller than the size of stamping dies hole 222.

### <Information Recording Method on Personal Certification Card and Surface Protection Method>

A face image, attribute information and a format printing were provided according to the following manner on the above-described IC card having been subjected to a stamping process to prepare a personal certification card.

### <Preparation of Ink Sheet for Sublimation Thermal Transfer Recording>

Ink sheets of three colors of yellow, magenta and cyan were obtained by providing a yellow ink layer coating solution, a magenta ink layer coating solution and a cyan ink layer coating solution of the following compositions on a polyethylene terephthalate sheet of 6 µm thick, the back-side thereof being subjected to anti-melt-adhesion treatment, so as to make each thickness of 1 µm.

### <Yellow Ink Layer Coating Solution>

| | |
|---|---|
| Yellow dye (Compound Y-1) | 3 parts |
| Polyvinylacetal (Product of Denki-Kagaku Ind. Co., Ltd.: Denkabutyral KY-24) | 5.5 parts |
| Polymethyl methacrylate modified polystyrene (Product of Toa-Goseikagaku Ind. Co., Ltd.: Lededa GP-200) | 1 part |
| Urethane modified silicone oil (Product of Dainichi-Seika Ind. Co., Ltd.: Diaromer SP-2105) | 0.5 parts |
| Methyl ethyl ketone | 70 parts |
| Toluene | 20 parts |

### <Magenta Ink Layer Coating Solution>

| | |
|---|---|
| Magenta dye (Compound M-1) | 2 parts |
| Polyvinylacetal (Product of Denki-Kagaku Ind. Co., Ltd.: Denkabutyral KY-24) | 5.5 parts |
| Polymethyl methacrylate modified polystyrene (Product of Toa-Goseikagaku Ind. Co., Ltd.: Lededa GP-200) | 2 parts |
| Urethane modified silicone oil (Product of Dainichi-Seika Ind. Co., Ltd.: Diaromer SP-2105) | 0.5 parts |
| Methyl ethyl ketone | 70 parts |
| Toluene | 20 parts |

### <Cyan Ink Layer Coating Solution>

| | |
|---|---|
| Cyan dye (Compound C-1) | 1.5 parts |
| Cyan dye (Compound C-2) | 1.5 parts |
| Polyvinylacetal (Product of Denki-Kagaku Ind. Co., Ltd.: Denkabutyral KY-24) | 5.6 parts |
| Polymethyl methacrylate modified polystyrene (Product of Toa-Goseikagaku Ind. Co., Ltd.: Lededa GP-200) | 1 part |
| Urethane modified silicone oil (Product of Dainichi-Seika Ind. Co., Ltd.: Diaromer SP-2105) | 0.5 parts |
| Methyl ethyl ketone | 70 parts |
| Toluene | 20 parts |

### <Preparation of Ink Sheets for Fusion Thermal Transfer Recording>

An ink sheet was obtained by coating and drying an ink layer coating solutions of the following compositions so as to make a thickness of 2 µm on a polyethylene terephthalate sheet of 6 µm thick, the back-side thereof being subjected to anti-melt-adhesion treatment.

### <Ink Layer Coating Solution>

| | |
|---|---|
| Carnauba wax | 1 part |
| Ethylene vinylacetate copolymer (Product of Mitsui Dupont Chemicals Co.: EV40Y) | 1 part |
| Carbon black | 3 parts |
| Phenol resin (Product of Arakawa-Kagaku Ind. Co., Ltd.: Tamanol521) | 5 parts |
| Methyl ethyl ketone | 90 parts |

### <Formation of Face Image>

A personal image having tone was formed on the image receiving layer by overlapping an image receiving layer and an ink-side of an ink sheet for sublimation thermal transfer recording, and heating from the ink sheet side by use of a thermal head under conditions of an output power of 0.23 W/dot, a pulse width of from 0.3 to 4.5 m·sec and a dot density of 16 dot/mm. In the image, dyes described above and nickel in the image receiving layer formed complexes.

### <Formation of Letter Information>

Letter information was formed on OP vanish by overlapping an OP vanish portion and an ink side of an ink sheet for fusion-type thermal transfer recording and heating from the ink sheet side by use of a thermal head under conditions of an output power of 0.5 W/dot, a pulse width of 1.0 m·sec and a dot density of 16 dot/mm.

### <Surface Protecting Method>

### <Preparation of Surface Protective Layer>

### <Preparation of Actinic-ray Curable Transfer Foil 1>

The following compositions were accumulated on a peeling layer of polyethylene terephthalate film 2 of 25 µm thick, on which a peeling layer comprised of fluorine resin layer of 0.1 µm had been provided, to prepare actinic-ray curable transfer foil 1.

### <Actinic-ray Curable Compound>

| | |
|---|---|
| Product of Shin-Nakamura Kagaku Co., Ltd.: A-9300 / Product of Shin-Nakamura Kagaku Co., Ltd.: EA-1020 = 35 / 1.75 parts | |
| Reaction initiator: Irgacure 184, manufactured by Ciba Geigie Co. | 5 parts |
| Additive: unsaturated group containing resin | 48 parts |
| Other additive: Surfactant F-179, manufactured by Dainippon Ink & Cemicals Inc. | 0.25 parts |

### <Intermediate Layer Coating Solution>

| | |
|---|---|
| Layer thickness: | 1.0 µm |
| Polyvinyl butyral resin (Product of Sekisui Chemicals Co., Ltd., Eslec BX-1) | 3.5 parts |
| Taftex M-1913 (Asahi Chemical Industry Co., Ltd.) | 5 parts |
| Hardener: Polyisocyanate (Coronate HX, manufactured by Nippon Polyurethane Co., Ltd.) | 1.5 parets |
| Methyl ethyl ketone | 90 parts |
| Curing after coating of a hardener was performed at 50°C for 24 hours. | |

### <Adhesive Layer Coating Solution>

| | |
|---|---|
| Layer thickness: | 0.5 µm |
| Urethane modified ethylene-ethylacrylate copolymer (Product of Toho Kagakukogyo Co., Ltd.: Hitech S6254B) | 8 parts |
| Polyacrylic acid ester copolymer (Product of Nippon Junyaku Co., Ltd.: Julimer AT510) | 2 parts |
| Water | 45 parts |
| Ethanol | 45 parts |

Further, a protective layer was transferred on the above-described image receiving layer on which images and letters were recorded, by utilizing actinic-ray curable transfer foil 1 comprised of the foregoing composition and by use of a heat roller of 5 cm diameter having a rubber hardness of 85 and being heated at a surface temperature of 200 °C and a pressure of 150 kg/cm² in 1.2 sec. The card prepared had a thickness of 760 µm and a rebound coefficient of a card was measured to be 0.61.

### <Example 2>

Example 2 was conducted with the same manner of Example 1 except that Module 2 was used.

### <Example 3>

Example 3 was conducted with the same manner of Example 1 except that Module 3 was used.

### <Example 4>

Example 4 was conducted with the same manner of Example 1 except that Module 4 was used.

### <Example 5>

Example 5 was conducted with the same manner of Example 1 except that Module 5 was used.

### <Example 6>

Example 6 was conducted with the same manner of Example 1 except that Module 6 was used.

### <Example 7>

Example 7 was conducted with the same manner of Example 1 except that Module 7 was used.

### <Example 8>

Example 8 was conducted with the same manner of Example 1 except that Module 8 was used.

### <Example 9>

Example 9 was conducted with the same manner of Example 1 except that Module 9 was used.

### <Example 10>

Example 10 was conducted with the same manner of Example 1 except that Module 10 was used.

### <Example 11>

Example 11 was conducted with the same manner of Example 1 except that Module 11 was used.

### <Example 12>

Example 12 was conducted with the same manner of Example 1 except that Module 12 was used.

### <Comparative Example 1>

Comparative Example 1 was conducted with the same manner of Example 1 except that Module 13 was used.

### <Comparative Example 2>

Comparative Example 2 was conducted with the same manner of Example 1 except that Module 14 was used.

### <Comparative Example 3>

Comparative Example 3 was conducted with the same manner of Example 1 except that Module 15 was used.

### <Evaluation>

### <Repeated Bending Test>

Repeated bending of 100 times was performed, being clamped on a chip, at an amplitude of 50 mm, a gap of 30 mm and 120 times/min, by use of a crumple tester of JIS K6404-6. IC operability was confirmed after the test.
A: All numbers are operable without problem,
B: 50% or more are operable or 50% or less show unstable operability,
C: 0% to 50% are operable or 50% or more show unstable operability,
D: All numbers are not operable.

### <Test of Strength against Point Pressure>

A load of 1 kg with a steel ball having a top edge diameter of 1 mm was applied 200 times to each of a circuit plane and a non-circuit plane of an IC-chip, placed on a rubber sheet having a hardness of 50. IC operability was confirmed after the test.
A: All numbers are operable without problem,
B: 50% or more are operable or 50% or less show unstable operability,
C: 0% to 50% are operable or 50% or more show unstable operability,
D: All numbers are not operable.

### <Impact Test>

By use of a dropping body type impact tester of JIS K5600·5-3, a card was rigidly fixed on a receiving table having a hole of 27 mm inner diameter by being sandwiched from upside and downside so that an IC-chip was positioned at the center, and a weight having a top edge diameter of 20 mm and a weight of 100 gf (S45C steel) was free dropped from a height of 10 cm on an IC-chip at the center of the receiving table. Movement, deformations and breaks were confirmed after the test.
A: All numbers are operable without problem,
B: 50% or more are operable or 50% or less show unstable operability,
C: 0% to 50% are operable or 50% or more show unstable operability,
D: All numbers are not operable.

### <Printing Ability (Roughness Property)>

A sublimation image was printed on a card prepared and degree of scratchiness was evaluated.
B: Printable without problems,
C: There is a portion of decreased density,
D: There is a portion of complete color missing.

The results are shown in Table 1.

**Table 1**

| | Module | CCA | Elastic-modulus kg/mm² | Filler content | C.C. layer thick µm | C.C. layer area | Chip thick µm | Chip shape | Result | | | |
|---|---|---|---|---|---|---|---|---|---|---|---|---|
| | | | | | | | | | Point Press test | Impact test | Repet. bend test | Print |
| Exam.1 | Module 1 | CCA 1 | 0.4 | 0 | 5 | *1 | 50 | Concave | A | A | A | B |
| Exam.2 | Module 2 | CCA 1 | 0.4 | 0 | 10 | *1 | 65 | Concave | A | A | A | B |
| Exam.3 | Module 3 | CCA 1 | 0.4 | 0 | 5 | *1 | 50 | Concave | A | A | A | B |
| Exam.4 | Module 4 | CCA 1 | 0.4 | 0 | 5 | *1 | 50 | Concave | A | A | A | B |
| Exam.5 | Module 5 | CCA 1 | 0.4 | 0 | 5 | *1 | 50 | Concave | A | A | A | B |
| Exam.6 | Module 6 | CCA 2 | 30 | 10% | 5 | *1 | 50 | Concave | A | B | A | B |
| Exam.7 | Module 7 | CCA 3 | 1 | 10% | 5 | *1 | 50 | Concave | A | A | A | B |
| Exam.8 | Module 8 | CCA 1 | 0.4 | 0 | 5 | *1 | 25 | Concave | B | A | A | B |
| Exam.9 | Module 9 | CCA 1 | 0.4 | 0 | 5 | *1 | 50 | Concave | A | A | A | B |
| Exam.10 | Module 10 | CCA 1 | 0.4 | 0 | 60 | *1 | 130 | Concave | B | B | A | C |
| Exam.11 | Module 11 | CCA 4 | 0.05 | 0 | 5 | *1 | 50 | Concave | A | B | B | B |
| Exam.12 | Module 12 | CCA 4 | 0.05 | 0 | 5 | *1 | 50 | Flat→ Concave | A | A | A | B |
| Comp. Exam.1 | Module 13 | CCA 5 | 60 | 0 | 5 | *1 | 180 | Flat | C | D | D | D |
| Comp. Exam.2 | Module 14 | CCA 1 | 0.4 | 0 | 2 | Chip or less | 180 | Flat | D | D | D | D |
| Comp. Exam.3 | Module 15 | CCA 1 | 0.4 | 0 | 5 | Chip or more | 130 | Concave→ Flat | B | D | D | C |

| | | | | | | | | | | | | |
|---|---|---|---|---|---|---|---|---|---|---|---|---|
| CCA: Close contacting agent, C.C. layer: Close contact layer, *1: Chip or more | | | | | | | | | | | | |

### INDUSTRIAL AVAILABILITY

As mentioned above, according to the present invention, problems in that a break of an IC-chip or a break of a card to make electric operation impossible are occurred in various situations, for example, durability against impact with rapid stress, repeated bending durability with repeated stress, and repeated localized load, can be solved. Further, not only to improve these durability, also a smoothness of a card surface on which a personal information is described is improved with a high level.

## Claims

1. An IC card, comprising:
an IC module (6) including
an IC chip (3) having a circuit surface side (3a) and an opposite side (3b) opposite to the circuit surface side (3a);
a reinforcement structural member (4) arranged adjacent to the opposite side (3b) of the IC chip (3); and
an antenna (5);
where the IC module (6) is incorporated in the IC card by filling with an adhesive (7a, 7b);
**characterised in that** the IC chip(3) is fixed to the reinforcement structural member (4) through a resin layer (9) such that the circuit surface (3a) side of the IC chip (3) is curved in a concave shape.

2. The IC card of claim 1, wherein the reinforcement structural member (4) has a chip side facing the IC chip and the chip side of the reinforcement structural member (4) is curved in the same curving shape of the IC chip (3).

3. The IC card of claim 1, wherein the IC chip (3) has a curved original shape and is fixed to the reinforcement structural member (4) such that the IC chip (3) is curved more than the curved original shape.

4. The IC card of claim 1, wherein the IC chip (3) is fixed by providing the resin layer (9) in a ring shape on the reinforcement structural member (4).

5. The IC card of claim 1, wherein the resin layer (9) contains a resin including an elastic filler and a hardenable resin.

6. The IC card of claim 1, wherein the resin layer (9) has an area larger than at least that of the circuit surface side (3a) and that of the opposite side (3b).

7. The IC card of claim 1, further comprising:
a holding layer to hold the circuit surface side (3a) of the IC chip (3) in a concave shape between the reinforcement structural member (4) on the opposite side (3b) toward the circuit surface side (3a) of the IC chip (3).

8. The IC card of claim 1, wherein the IC chip (3) has a thickness of 25 µm to 110 µm and the resin layer (9) has a thickness of 3 µm to 50 µm.

9. The IC card of claim 1, wherein the IC chip (3) is fixed to the reinforcement structural member (4) through the resin layer (9) having a 2% elastic modulus of 0.1 kg/mm² to 55kg/mm².

10. The IC card of claim 1, wherein the IC card has a surface having an image receiving layer provided with personal identification information including at least name and a facial image and a surface having a writing layer to allow writing thereon.

11. The IC card of claim 1, wherein the IC chip (3) comprises a laminated structure of at least a silicon substrate, a semiconductor layer, a circuit forming layer and a protecting layer in this order.

12. An IC card producing method of producing an IC card in which an IC module (6) having an IC chip (3) having a circuit surface side (3a) and a opposite side (3b) opposite to the circuit surface side (3a), a reinforcement structural member (4) arranged adjacent to the opposite side (3b) of the IC chip (3), an antenna (5) and an adhesive layer (9) are incorporated, comprising the steps of:
maintaining a condition that the circuit surface side (3a) of the IC chip (3) is curved in a concave shape; and
fixing the IC chip (3) on the reinforcement structural member (4).

13. The IC card producing method of claim 12, wherein the IC chip (3) is fixed on the reinforcement structural member (4) by a pushing tool (20) having a curve in the same curving direction as the curve of the IC chip (3).

14. The IC card producing method of claim 13, wherein the IC chip (3) is fixed on the reinforcement structural member (4) by pushing at least a part of the IC chip (3) other than a outer peripheral portion of the IC chip with the pushing tool (20).

## Patentansprüche

1. Chipkarte, umfassend:
ein Chipmodul (6), das
einen IC-Chip (3) mit einer Schaltungsoberflächenseite (3a) und einer entgegengesetzten Seite (3b), die zur Schaltungsoberflächenseite (3a) entgegengesetzt ist;
ein Verstärkungsstrukturelement (4), das angrenzend an die entgegengesetzte Seite (3b) des IC-Chips (3) angebracht ist; und
eine Antenne (5) umfasst;
wobei das Chipmodul (6) in die Chipkarte durch Füllen mit einem Klebstoff (7a, 7b) eingearbeitet ist;
wobei die Chipkarte **dadurch gekennzeichnet ist, dass** der IC-Chip (3) an dem Verstärkungsstrukturelement (4) durch eine Harzschicht (9) derart fixiert ist, dass die Schaltungsoberflächenseite (3a) des IC-Chips (3) in einer konkaven Form gekrümmt ist.

2. Chipkarte nach Anspruch 1, wobei das Verstärkungsstrukturelement (4) eine zum IC-Chip weisende Chipseite aufweist und die Chipseite des Verstärkungsstrukturelemente (4) in der gleichen Krümmungsform des IC-Chips (3) gekrümmt ist.

3. Chipkarte nach Anspruch 1, wobei der IC-Chip (3) eine gekrümmte Originalform aufweist und an dem Verstärkungsstrukturelement (4) derart fixiert ist, lass der IC-Chip (3) stärker als die gekrümmte Originalform gekrümmt ist.

4. Chipkarte nach Anspruch 1, wobei der IC-Chip (3) durch Bereitstellen der Harzschicht (9) in Ringform auf dem Verstärkungsstrukturelement (4) fixiert ist.

5. Chipkarte nach Anspruch 1, wobei die Harzschicht (9) ein Harz enthält, das einen elastischen Füllstoff und ein härtbares Harz umfasst.

6. Chipkarte nach Anspruch 1, wobei die Harzschicht (9) eine größere Fläche als mindestens die der Schaltungsoberflächenaeite (3a) und die der entgegengesetzten Seite (3b) aufweist.

7. Chipkarte nach Anspruch 1, die ferner eine Halteschicht zum Halten der Schaltungsoberflächenseite (3a) des IC-Chips (3) in einer konkaven Form zwischen dem Verstärkungsstrukturelement (4) auf der entgegengesetzten Seite (3b) in Richtung der Schaltungeoberflächenseite (3a) des IC-Chips (3) umfasst.

8. Chipkarte nach Anspruch 1, wobei der IC-Chip (3) eine Dicke von 25 µm bis 110 µm aufweist und die Harzschicht (9) eine Dicke von 3 µm bis 50 µm aufweist.

9. Chipkarte nach Anspruch 1, wobei der IC-Chip (3) an dem Verstärkungsstrukturelement (4) über die Harzschicht (9), die ein 2-%-Elastizitätsmodul von 0,1 kg/mm² bis 55 kg/mm² aufweist, fixiert ist.

10. Chipkarte nach Anspruch 1, wobei die Chipkarte eine Oberfläche mit einer Bildempfangsschicht die mit Informationen zur persönlichen Identifizierung, die mindestens den Namen und ein Gesichtsbild umfassen, ausgestattet ist, und eine Oberfläche mit einer Schreibschicht, auf der Schreiben möglich ist, aufweist.

11. Chipkarte nach Anspruch 1, wobei der IC-Chip (3) eine Laminatstruktur aus mindestens einem Siliciumsubstrat, einer Halbleiterschicht, einer Schaltungsbildungsschicht und einer Schutzschicht in dieser Reihenfolge umfasst.

12. Chipkartenherstellungsverfahren zur Herstellung einer Chipkarte, in die ein Chipmodul (6), das einen IC-Chip (3) mit einer Schaltungsoberflächenseite (3a) und einer entgegengesetzten Seite (3b), die zur Schaltungsoberflächenseite (3a) entgegengesetzt ist, ein Verstärkungsstrukturelement (4), das angrenzend zur entgegengesetzten Seite (3b) des IC-Chips (3) angebracht ist, eine Antenne (5) aufweist, und eine Klebstoffschicht (9) eingearbeitet sind,
wobei das Verfahren die Stufen des Aufrechterhaltens eines Zustands, wobei die Schaltungsoberflächenseite (3a) des IC-Chips (3) in einer konkaven Form gekrümmt ist, und des Fixierens des IC-Chips (3) an dem Verstärkungsstrukturelement (4) umfasst.

13. Chipkartenheretellungsverfahren nach Anspruch 12, wobei der IC-Chip (3) an dem Verstärkungsstrukturelement (4) durch ein Schubwerkzeug (20) mit einer Krümmung in der gleichen Krümmungsrichtung wie die Krümmung des IC-Chips (3) fixiert wird.

14. Chipkartenherstellungsverfahren nach Anspruch 13, wobei der IC-Chip (3) an dem Verstärkungsstruksturelement (4) durch Drücken von mindestens einem anderen Teil des IC-Chips (3) als dem äußeren Umfangsbereich des IC-Chips mit dem Schubwerkzeug (20) fixiert wird.

## Revendications

1. Carte à circuit intégré (IC), comprenant :
un module IC (6) incluant :
une puce de circuit intégré (3) ayant une face de surface de circuit (3a) et une face opposée (3b), opposée à la face de surface de circuit (3a);
un organe structurel de renforcement (4), disposé de façon adjacente à da face opposée (3b) de la puce électronique IC(3); et
une antenne (5);
dans laquelle le module IC (6) est incorporé dans la carte IC par remplissage avec un adhésif (7a; 7b);
**caractérisée en ce que** la puce de circuit intégré (IC) (3) est fixée à l'organe structurel de renforcement (4) par une couche en résine (9) elle que la face de surface (3a) de la puce de circuit intégré (IC) (3) soit incurvée selon une forme concave.

2. Carte à circuit intégré (IC) selon la revendication 1, dans laquelle l'organe structurel de renforcement (4) présente une face de puce électronique placée en regard de la puce électronique IC, et la face de puce électronique de l'organe structurel de renforcement (4) est incurvée à la même forme de courbure que celle de la puce électronique IC (3).

3. Carte à circuit intégré (IC) selon la revendication 1, dans laquelle la puce électronique IC (3) présente une forme originelle incurvée et est fixée à l'organe structurel de renforcement (4) de manière que la puce électronique IC (3) soit incurvée plus fortement que la forme originelle incurvée.

4. Carte à circuit intégré (IC) selon la revendication 1, dans laquelle la puce électronique IC (3) est fixée en plaçant la couche en résine (9) selon une forme en anneau sur l'organe structurel de renforcement (4).

5. Carte à circuit intégré (IC) selon la revendication 1, dans laquelle la couche en résine (9) contient une résine incluant une charge élastique et une résine durcissable.

6. Carte IC selon la revendication 1, dans laquelle la couche en résine (9) présente une surface plus grande qu'au moins celle de la face le surface de circuit (3a) et de la face opposée (3b).

7. Carte de circuit intégré (IC) selon la revendication 1, comprenant en outre :
une couche de maintien, pour maintenir la face de surface de circuit (3a) de la puce de circuit intégré (3) selon une forme concave entre l'organe structurel de renforcement (4), sur la face opposée (3b), et la face de surface de circuit (3a) de la puce électronique IC (3).

8. Carte de circuit intégré (IC) selon la revendication 1, dans laquelle la puce électronique IC (3) présente une épaisseur de 25 µm à 110 µm, et la couche en résine (9) présente une épaisseur de 3 µm à 50 µm.

9. Carte de circuit intégré (IC) selon la revendication 11, dans laquelle la puce électronique IC (3) est fixée sur l'organe structurel de renforcement (4) par la couche en résine (9), ayant un module d'élasticité à 2 % d'une valeur de 0,1 kg/mm² à 55 kg/mm².

10. Carte de circuit intégré (IC) selon la revendication 1, dans laquelle la carte IC présente une surface ayant une couche réceptrice d'image, munie d'informations d'identification personnelle, incluant au moins le nom et une image faciale, et une surface ayant une couche d'écriture pour permettre d'écrire sur elle.

11. Carte de circuit intégré (IC) selon la revendication 1, dans laquelle la puce de circuit intégré (3) présente une structure en couches, formée d'au moins un substrat en silicium, d'une couche en semi-conducteur, d'une couche formant des circuits et d'une couche protectrice, dans cet ordre.

12. Procédé de fabrication d'une carte de circuit intégré (IC), pour produire une carte de circuit intégré (IC), dans laquelle sont incorporés un module IC (6), comprenant une puce électronique ayant une face de surface de circuit (3a) et une face opposée (3b), opposée à la face de surface de circuit (3a), un organe structurel de renforcement disposé de façon adjacente à la face opposée (3b) de la puce électronique IC (3), une antenne (5) et une couche d'adhésive (9), comprenant des étapes consistant à :
maintenir un état tel que la face de surface de circuit (3a) de la puce électronique IC (3) soit incurvée selon une forme concave; et
fixer la puce électronique IC (3) sur l'organe structurel de renforcement (4).

13. Procédé de fabrication d'une carte IC selon la revendication 12, dans lequel la carte IC (3) est fixée sur l'organe structurel de renforcement (4) par un outil de poussée (20) ayant une courbure orientée dans le même sens de courbure que la courbure de la puce électronique IC (3).

14. Procédé de fabrication d'une carte IC selon la revendication 13, dans lequel la puce électronique IC (3) est fixée sur l'organe structurel de renfoncement (4), en poussant au moins une partie de la puce électronique IC (3), autre qu'une partie extérieure de la puce électronique IC, avec l'outil de poussée (20).
